(19) **Europäisches Patentamt**
**European Patent Office**
**Office européen des brevets**

(11) **EP 4 759 606 A1**

(12) **EUROPEAN PATENT APPLICATION**

(43) Date of publication:
**17.06.2026 Bulletin 2026/25**

(21) Application number: **24219136.9**

(22) Date of filing: **11.12.2024**

(51) International Patent Classification (IPC):
**B60L 3/00** (2019.01)    **B60L 58/12** (2019.01)
**B60L 58/25** (2019.01)    **B60L 58/26** (2019.01)
**G01R 31/3842** (2019.01)    **G01R 31/389** (2019.01)
**H01M 10/48** (2006.01)    **H01M 10/42** (2006.01)
**H01M 10/44** (2006.01)    **H01M 10/613** (2014.01)

(52) Cooperative Patent Classification (CPC):
**B60L 3/0046; B60L 58/12; B60L 58/25;**
**B60L 58/26; G01R 31/3842; G01R 31/389;**
**H01M 10/4207; H01M 10/425; H01M 10/441;**
**H01M 10/482; H01M 10/486; H01M 10/613;**
**B60L 2240/545; B60L 2240/547; B60L 2240/549;**
(Cont.)

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **ABB SCHWEIZ AG**
**5400 Baden (CH)**

(72) Inventors:
• **TIBERI, Lorenzo**
**8953 Dietikon (CH)**

• **HE, Minglong**
**4310 Rheinfelden (CH)**
• **BAUR, Matthias**
**5034 Suhr (CH)**
• **LANDMANN, Daniel**
**4125 Riehen (CH)**
• **WLODARCZYK, Jakub Karol**
**8048 Zurich (CH)**

(74) Representative: **Maiwald GmbH**
**Engineering**
**Elisenhof**
**Elisenstrasse 3**
**80335 München (DE)**

(54) **EARLY THERMAL RUNAWAY EVENT IDENTIFICATION METHOD OF A BATTERY CELL**

(57) The computer-implemented method for early identification of thermal runaway events in a battery cell within a battery pack involves several steps. Initially, it involves receiving the current and voltage of the battery cell, as well as the temperature and state of charge (SOC) level of the battery pack. Next, the method obtains the Direct Current Internal Resistance (DCIR) value based on the received current and voltage of the battery cell. This obtained DCIR value is then compared with a prestored DCIR value from a reference table, which contains multiple prestored DCIR values corresponding to different temperatures and SOC levels of the battery pack. The comparison is made within the same temperature and SOC level ranges. If the calculated DCIR value exceeds the prestored DCIR value by at least a multiple of a first threshold, a thermal runaway event is identified.

Figure 5

(52) Cooperative Patent Classification (CPC): (Cont.)
     H01M 2010/4271

**Description**

FIELD OF THE INVENTION

The invention pertains to an early thermal runaway event identification method of a battery cell, a system, a computer-readable medium and a computer program product. Specifically, the present disclosure pertains to obtaining Direct Current Internal Resistance (DCIR) values and comparing them with prestored reference values to detect potential thermal runaway conditions of a battery cell.

BACKGROUND

In the field of battery technology, ensuring the safety and reliability of battery packs, particularly those used in electric vehicles or energy storage systems, is of paramount importance. Battery packs are composed of numerous individual battery cells, and the performance and safety of the entire pack depend on the health and stability of each cell. One of the critical safety concerns in battery packs is the occurrence of thermal runaway events, which can lead to catastrophic failures, especially battery venting, which can cause fires and explosions. The venting of a battery cell describes that the battery cell overheats due to a thermal runaway and eventually bursts open setting free hot gases, that might also be ignited. Due to the close packaging of battery cells in a battery pack, this venting process is likely to also cause surrounding battery cells to overheat, which can lead to a venting chain reaction. Known systems especially involve monitoring the temperature of a battery pack to detect potential issues. However, these systems often lack the precision and responsiveness needed to identify early signs of an active thermal runaway, which can develop rapidly and unpredictably.

Current approaches to thermal runaway detection often rely on temperature sensors distributed throughout the battery pack. While this approach of temperature monitoring might seem to be an obvious solution, it may not provide sufficient early warning of a thermal runaway event. By the time a significant temperature rise is detected, the thermal runaway process may already be well underway, making it difficult to mitigate the situation effectively. Additionally, temperature sensors can sometimes fail or provide inaccurate readings due to their placement on the battery cell, leading to false positives or missed detections. Moreover, providing a multitude of temperature sensors in a battery pack, preferably more than one per batter cell for each battery cell, it is not economical. For this reason, some systems for thermal runaway detection rely on the detection of smoke fumes emerging during battery cell venting. However, this approach does obviously not allow for any warning time before the hazardous venting takes place.

Another common method involves monitoring the voltage and current of the battery cells. While changes in these parameters can indicate potential issues, they are often influenced by various factors such as the state of charge (SOC) and operating conditions, making it challenging to distinguish between normal fluctuations and signs of impending thermal runaway. Moreover, the internal resistance of battery cells, which can provide valuable insights into their health and stability, is not always adequately monitored or analysed in real-time. Known systems may lack the capability to correlate internal resistance changes with specific temperature and SOC conditions, limiting their effectiveness in early detection.

Despite the substantial advances in the field of battery management systems (BMS) and energy management systems (EMS), there remains a need for improved methods to identify early thermal runaway events in battery cells. Existing solutions often fail to provide the necessary accuracy and timeliness required to prevent the catastrophic consequences of a failure. It is therefore a technical problem underlying the present invention to provide a method and system for early thermal runaway event identification in battery cells that at least partially overcomes the disadvantages of known systems.

SUMMARY

The invention provides a method, system, computer program product, and computer-readable medium according to the independent claims, which overcome one or more of the above-mentioned problems of the prior art. Preferred embodiments are laid down in the dependent claims.

According to an aspect of the invention, a method for early identification of thermal runaway events in a battery cell within a battery pack involves the following steps. Initially, it involves receiving the current and voltage of the battery cell, as well as the temperature and state of charge (SOC) level of the battery pack. Next, the method comprises obtaining a Direct Current Internal Resistance (DCIR) value based on the received current and voltage of the battery cell. This obtained DCIR value is then compared with a prestored DCIR value from a reference table, which contains multiple prestored DCIR values corresponding to different temperatures and SOC levels of the battery pack. The comparison is made within the same temperature and SOC level ranges. If the calculated DCIR value exceeds the prestored DCIR value by at least a multiple of a first threshold, a thermal runaway event is identified.

In other words, by using the correlation between DCIR, temperature and SOC level, a thermal runaway event can be identified so early that countermeasures might still be applied to prevent the thermal runaway.

The term "Direct Current Internal Resistance", as used herein, relates to an internal resistance of a battery cell. This internal resistance is due to the battery cell not being a perfect current source in real life.

The term "state of charge", as used herein, relates to a quantification of a remaining capacity available in a battery cell at a given time and in particular in relation to a given state of ageing.

The advantages of this method include the ability to detect thermal runaway events early, allowing for preventive measures to be taken before the event occurs, thus enhancing the safety and reliability of the battery system. Additionally, this method does not require additional sensing units (beyond those that are already available for the BMS to provide battery readings) and can effectively handle the regular increase of the battery resistance over its lifetime due to aging effects. The method may work only employing the battery module temperature to categorize the measured DCIR value in the reference table.

The first threshold may optionally be set to a multiple of 4 or more of the dedicated prestored DCIR value. Optionally, the first threshold may be especially set to a multiple of 8 or more. Further optionally, depending on the battery cell type (e.g. Lithium-Ion, Sodium-Ion), and/or more specifically the battery cell technology (e.g., LFP, LCO, LMO NCA, NMC, LTO, NaS, ZEBRA, NalBs), the first threshold may also be set higher in the range of one and up to two magnitudes.

According to the present disclosure, the thermal runaway may be a process that is accelerated by increased temperature. This acceleration may cause the release of energy which usually leads to a further temperature increase. Thereby, the system is forming a positive feedback loop, that, if the energy (temperature) cannot be controlled (e.g. due to lack of cooling), results in an uncontrolled positive feedback loop. For battery cells (such as rechargeable ones), the thermal runaway event describes a process of continuous heat increase, that will rapidly cause the battery cell (also referred to as battery or cell) to overheat. Once the thermal runaway event sufficiently started (the point of turning from controlled positive feedback to uncontrolled positive feedback), which may be the point where no sufficient cooling can be provided to the battery cell to compensate for the current temperature rise, the overheating process of a battery cell can generally not be stopped (generally as for general application under normal operating conditions, hence without having additional advanced cooling). This overheating process may most likely cause the battery cell to explode. To reduce the effects of an arbitrary explosion, batteries may usually have a vent, which is a predetermined structure in the housing of the battery cell that poses a purposely constructed weak point. When the battery is inflated due to gases generated by the exothermic reaction, the vent will eventually rupture allowing for the overpressure release to happen at the predefined position of the vent. Though, the hot gases, that might also be ignited and are emitting from the cell, could also cause surrounding battery cells to also rapidly undergo a thermal runaway event. This can cause a dangerous chain reaction. For this reason, it is advantageous to detect a thermal runaway event before the venting of a battery cell takes place. This allows to gain time to prepare (e.g., take countermeasures or issue warnings, such as cutting the power to the battery, maximise cooling, alert firefighters, evacuate the peripherals) before the impending venting takes place.

According to the present disclosure, the battery cells may be individual electrochemical cells that store and provide electrical energy. The battery cell may be also referred to as battery or cell. The battery cell can be of different structures (e.g., cylindrical, prismatic, pouch).

According to the present disclosure, the battery pack may be composed of multiple battery cells. Optionally, a battery pack can also be composed of multiple battery modules, wherein a battery module is composed of multiple battery cells. Multiple battery packs in a row (in the sense of forming a line in the three-dimensional space) may be referred to as battery rack or rack. A battery storage may consist of at least one battery module. The battery storage may form a Battery Energy Storage System (BESS). This may be formed by multiple battery modules that are (optionally stacked and) situated in containers.

According to the present disclosure, the receiving of a battery cell current of the battery cell may refer to receiving the current of the battery cell from the at least one system that is at least monitoring (optionally, additionally also controlling) the battery cells. Such a system may be the battery management system (BMS) or the energy management system (EMS), wherein the EMS may refer to a system providing more advances functionalities compared to the BMS. The EMS may monitor at least one BMS. The main function of the BMS may be to keep any single battery cell of the battery pack inside its safe operating area by monitoring the following physical quantities: current, single cell voltage, and battery pack temperature. Based on these quantities, the battery can not only be operated safely, but also the level of state of charge (SOC) and level of state of health (SOH) can be computed. The calculation may require further absolute term, e.g., the current consumed by the loss reactions, the rated capacity of the battery cell, maximal releasable capacity, releasable capacity. A battery storage may consist of several battery cells stacked in series. Higher voltages can be reached by stacking more battery cells. The charge current and the discharge current may be the same for all the cells, but voltages may have to be monitored (e.g. by the BMS and/or the EMS) on every single cell (single cell voltage). Hence, the BMS and/or the EMS may already be monitoring the current of the battery cells (battery cell current), and the single cell voltage (battery cell voltage), such as a temperature of the battery pack (by employing one or more temperature sensors arranged in or round the battery pack). Hence, the battery cell current, the battery cell voltage and the SOC level may be provided by the BMS and/or the EMS.

According to the present disclosure, the temperature of the battery pack may refer to a temperature of the battery pack. This temperature may however not be representing the temperature of each battery cell of the battery pack, as the battery cells' temperature may vary in comparison to the location where the temperature of the battery pack is obtained. Therefore, the temperature of the battery pack may only represent an approximation value which can be partially converted to a battery cell's temperature. This is most likely only true under normal operation and not for a thermal runaway event, as the battery pack's temperatures sensor may probably not be close to the battery cell that is undergoing a thermal runaway. Depending on the shape of the battery cell, the battery cell might also heat up on one end but a temperature sensor on another end of the battery might not be able to detect the heat.

According to the present disclosure, the reference table may refer to a table that contains SOC levels and temperatures on the x- and y-axis (or vice versa) and a DCIR value dedicated for each of combination of a SOC level and a temperature. The reference table may not be of an arbitrary accuracy for each temperature and SOC level. The reference table may be constructed of SOC level steps (e.g. of 1%, 2% or 3%) and temperature steps (e.g. of 2, 5 or 10 degrees Celsius). The reference table may be a look-up table (LUT). An example for such a reference table could can be seen in table 1:

Table 1

|  | T1 | T2 | T3 | ......... | Tn |
|---|---|---|---|---|---|
| SOC$_1$ |  |  |  |  |  |
| SOC$_2$ |  | DCIR$_{22}$ | DCIR$_{23}$ |  |  |
| SOC$_3$ |  | DCIR$_{32}$ | DCIR$_{33}$ |  |  |
| --- |  |  |  |  |  |
| SOCn |  |  |  |  |  |

According to the present disclosure, the temperature range and/or the SOC level range may refer to a temperature and/or that lie within one step of the reference table. E.g. for a step of 2% SOC, the levels of 50,1% and 50,5% would both lie within the same SOC level range and (when being within a same temperature range) would be dedicated one common DCIR value.

According to the present disclosure, the prestored DCIR values in the reference table may refer to the DCIR values that are already present in the reference value.

According to the present disclosure, that the obtained DCIR value exceeds the prestored DCIR value by a first threshold may refer to a factor (ratio) by which the obtained DCIR value exceeds the prestored DCIR value. If the obtained DCIR value would be double of the prestored DCIR value, the obtained DCIR value exceeds by (a factor of) 2.

In a preferred embodiment, the comparing the obtained DCIR value with a prestored DCIR value may further comprise: obtaining an average DCIR value at the same temperature range of the battery pack and at the same SOC level range of the battery pack of a plurality of the battery cells of the battery pack, and when the first condition is met, validating the thermal runaway event, when a second condition is met, the second condition comprises that the obtained DCIR value exceeds the average DCIR value by a second threshold.

According to the present disclosure, the average DCIR value may be obtained for the battery cells that are arranged next to or close to the battery cell that exceeded the first threshold. Optionally, the average DCIR value may be obtained for all battery cells of the battery pack.

The second threshold may optionally be set to a multiple of 4 or more of the dedicated prestored DCIR values. Optionally, the second threshold may be especially set to a multiple of 8 or more.

According to the present disclosure, that the obtained DCIR value exceeds the average DCIR value by a second threshold may refer to a factor (ratio) by which the obtained DCIR value exceeds the average DCIR value. If the obtained DCIR value would be double of the average DCIR value, the obtained DCIR value exceeds by (a factor of) 2.

The implementation introduces additional mechanisms for validating a thermal runaway event in a battery cell by incorporating an average DCIR value from multiple battery cells within the battery pack and comparing this average value to the obtained DCIR value of battery cell that exceeded the first threshold. This comparison may be used to further validate the occurrence of a thermal runaway event by checking if the dobtained DCIR value exceeds the average DCIR value by a second threshold. Hence, the chance for a false-positive thermal runaway event detection can be reduced. The second condition may be that the obtained DCIR value exceeds the average DCIR value by a second threshold, which may be a value of 4 or more. This additional step may enhance the accuracy and reliability of identifying a thermal runaway event by not only comparing the dobtained DCIR value with a prestored DCIR value but also with an average DCIR value derived from multiple cells. This method may provide a more robust validation mechanism by incorporating a second threshold comparison, which may help in reducing false positives and ensuring that the identified thermal runaway event is indeed significant. This enhancement may be particularly useful in large battery packs where variations among individual cells may occur, and an average value may provide a more representative baseline for comparison. By implementing this additional comparison step, the method may achieve a higher level of precision in detecting potential thermal runaway events, which may be critical for the safety and reliability of battery packs in various applications. This may further reduce the time that would be required for obtaining new values in order to verify that the values would still be out of bounds. This can save valuable time for taking countermeasures before a venting may take place.

In a preferred embodiment, the receiving a battery cell current of the battery cell and a battery cell voltage of the battery cell may further comprise that the battery cell current and the battery cell voltage may both be received before and after a current change in the battery cell.

This additional step may provide a more dynamic and responsive assessment of the battery cell's condition, potentially allowing for more accurate detection of anomalies that may indicate an early thermal runaway event. By incorporating measurements taken before and after a current change, the method may capture transient behaviours and fluctuations that will not be evident from static measurements alone. This approach may enhance the sensitivity and reliability of the thermal runaway detection process, as it may account for variations in the battery cell's performance under different operating conditions. This enhanced method may thus provide a more comprehensive and nuanced approach to monitoring battery health, potentially improving the safety and reliability of battery packs in various applications.

In a preferred embodiment, the method may involve, upon detecting a thermal runaway, reducing the load of the battery cells and/or decreasing the temperature of the battery cells.

The new features introduced in the implementation may provide a proactive response mechanism once a thermal runaway event is detected. Reducing the load of the battery cells may involve decreasing the current drawn from the cells, which may help in preventing further escalation of the thermal event. Reducing the load may also comprise to disconnect the battery pack. Decreasing the temperature of the battery cells may involve activating cooling systems or other thermal management strategies to dissipate heat and stabilize the temperature. This integrated approach may enhance the safety and reliability of the battery pack by not only identifying potential thermal runaway events early but also taking immediate corrective actions to at least reduce damage, delaying a battery cell venting and ensure safe operation. The implementation may therefore add a critical layer of safety by addressing both detection and response, ensuring that the battery pack can effectively manage thermal risks.

In a preferred embodiment, the current change is externally induced.

The implementation introduces a feature where the current change may be externally induced. This implies that the method may include a mechanism by which an external source or system may deliberately alter the current flowing through the battery cell. This external induction of current change may be achieved through various means such as an external controller, a diagnostic tool, or a testing apparatus that may interface with the BMS and/or EMS. The new feature of externally induced current change may bring several advantages to the early thermal runaway event identification method. It may allow for more controlled and precise testing conditions, enabling the system to determine the cell current more precisely. This may enhance the reliability and accuracy of the thermal runaway detection process. Additionally, the ability to externally induce current changes may provide a means for periodic testing and validation of the battery pack's safety mechanisms, even if the battery packs load cycle would not foresee any current changes, hence hindering a precise current determination. Overall, the introduction of externally induced current change may significantly enhance the robustness and versatility of the early thermal runaway event identification method, providing a valuable tool for ensuring the safety and reliability of battery packs in various applications.

In a preferred embodiment, the receiving the battery cell current and the battery cell voltage may be performed regularly.

Optionally, for obtaining the DCIR value, reception of the battery cell current and voltage may be performed at intervals of at least every 30 seconds. This regular monitoring may involve the use of a current pulse that is at least 0.1 C and lasts for at least 1 second.

The C Rating of a battery is a measurement of the current well-known in the field at which the battery is charged and discharged. It is expressed as a multiple of the battery's capacity. For example, a C Rating of 1C means that the battery can provide (at least for a time period) a current that is equal to its capacity for one hour (e.g., 1C for 2Ah is 2A).

The new feature brought by this implementation may enhance the precision and reliability of the early thermal runaway event identification method by ensuring that the battery cell current and voltage are consistently and frequently measured. This regular measurement may allow for the timely detection of any anomalies in the Direct Current Internal Resistance (DCIR) values, which may be crucial for identifying potential thermal runaway events at an early stage to increase warning time before the possible venting of a battery. By specifying the duration and magnitude of the current pulse, the implementation may ensure that the measurements are robust and reflective of the actual conditions within the battery cell. This may help in reducing the likelihood of false positives or negatives in the detection process. Additionally, the regular interval of measurement may provide a more comprehensive dataset overtime, which may improve the accuracy of comparisons with the prestored DCIR values in the reference table. This may be particularly important in dynamic environments where the temperature and state of charge (SOC) levels of the battery pack may fluctuate. The integration of these specific parameters may also facilitate the development of more sophisticated algorithms for thermal runaway detection, potentially leading to more advanced and reliable battery management systems. Overall, the implementation may significantly contribute to the robustness and effectiveness of the early thermal runaway event identification method by ensuring that the critical parameters of battery cell current and voltage are monitored with a high degree of regularity and precision.

In a preferred embodiment, the battery cell current and/or the battery cell voltage may be provided by a BMS of the battery pack. Optionally or additionally, the battery cell current and the battery cell voltage are provided by an EMS of the battery pack. BMS and/or EMS of the battery pack may refer to a BMS and/or EMS that is dedicated to at least monitoring the battery cell(s) of a battery pack.

The implementation introduces a specific mechanism of communication between components by specifying that the battery cell current and the battery cell voltage are provided by a BMS and/or EMS of the battery pack. This feature brings several advantages and enhancements to the early thermal runaway event identification method described in the aspect. By integrating the BMS and/or EMS as the source of the battery cell current and voltage data, the method leverages the existing infrastructure of the battery pack, which is typically equipped with a BMS and/or EMS for monitoring and managing the performance and safety of the battery cells. The BMS and/or EMS is designed to continuously monitor various parameters of the battery cells, including current, voltage, temperature, and state of charge (SOC), and it often has built-in communication protocols and data logging capabilities. Utilizing the BMS and/or EMS for providing the necessary data ensures that the method can access accurate and real-time information without the need for additional sensors or data acquisition systems, thereby reducing complexity and cost. Furthermore, the BMS and/or EMS is typically calibrated and synchronized with the battery pack's operational parameters, ensuring that the data it provides is consistent and reliable. This integration enhances the robustness of the method by minimizing potential discrepancies or errors that could arise from using separate measurement systems. Additionally, the BMS and/or EMS can facilitate the implementation of the method by providing a centralized platform for data collection and analysis, streamlining the process of obtaining the Direct Current Internal Resistance (DCIR) value and comparing it with the prestored DCIR values in the reference table. By relying on the BMS and/or EMS, the method can also benefit from the BMS's and/or EMS's diagnostic and fault detection capabilities, which can further improve the accuracy and timeliness of identifying thermal runaway events. Overall, the inclusion of the BMS and/or EMS as the source of battery cell current and voltage data enhances the method's efficiency, reliability, and integration with existing battery management systems, making it a more practical and effective solution for early thermal runaway event identification in battery packs.

In a preferred embodiment, the reference table may comprise a charge table and/or a discharge table.

The implementation introduces the concept of a reference table that may comprise a charge table and/or a discharge table. The charge table may contain a plurality of prestored DCIR values for a combination of different temperatures of the battery pack and different SOC levels of the battery pack during a charge event of the battery cell. Similarly, the discharge table may include a plurality of prestored DCIR values for a combination of different temperatures of the battery pack and different SOC levels of the battery pack during a discharge event of the battery cell. This feature may enhance the method by providing more specific and detailed data for different operational states of the battery cell, which may improve the accuracy of thermal runaway event identification. By distinguishing between charge and discharge events, the method may more precisely obtain the DCIR values relevant to the current state of the battery cell, thereby potentially increasing the reliability of the thermal runaway detection. The communication between components may involve the battery management system or a similar control unit accessing the reference table to retrieve the appropriate DCIR values based on the current operational state of the battery cell. This system may then compare the obtained DCIR value with the prestored values in the charge or discharge table, depending on whether the battery cell is currently charging or discharging. This additional layer of specificity may allow for a more nuanced and accurate identification of early thermal runaway events, as the method may take into account the different behaviours of the battery cell under varying conditions. The inclusion of both charge and discharge tables may also provide a more comprehensive dataset, which may further refine the method's ability to detect anomalies indicative of thermal runaway. This feature may ultimately contribute to enhanced safety and performance of the battery pack by enabling more timely and precise identification of potential thermal runaway events.

In a preferred embodiment, the comparing the obtained DCIR value with a prestored DCIR value may further comprise: if neither the first condition nor the second condition are met, updating the corresponding prestored DCIR value of the reference table with the obtained DCIR value.

This updating mechanism may ensure that the reference table remains current and reflective of the actual performance characteristics of the battery cells over time. By allowing the prestored DCIR values to be updated with the newly obtained DCIR values, the system may adapt to changes in the battery cells' behaviour, which may occur due to aging, usage patterns, or environmental factors. This feature may improve the reliability of the thermal runaway event identification method by reducing the likelihood of false positives or negatives. The communication between components may involve the battery management system receiving the battery cell current, voltage, temperature, and SOC level, then obtaining the DCIR value and comparing it with the prestored values in the reference table. If the conditions for updating are met, the system may then update the reference table with the new DCIR value. This dynamic updating process may allow the system to maintain an accurate and up-to-date reference for identifying potential thermal runaway events, thereby enhancing the overall safety and performance of the battery pack. The new feature may bring a level of self-correction and learning to the system, which may be particularly beneficial in applications where battery performance and safety are critical. By continuously updating the reference table, the method may account for gradual changes in the battery cells' characteristics, ensuring that the identification of thermal runaway events remains precise and effective over the lifespan of the battery pack. This approach may also reduce the need for manual recalibration or intervention, as the system may autonomously adjust its parameters based on real-time data, thereby providing a more robust and reliable solution for early thermal runaway event identification. In addition, this approach may allow to start the procedure with an empty reference table that is finally created/filled during a first calibration run. During said calibration run, the first condition may not be calculated, and thermal runaway detection might just be subjected to employing the second condition for the duration of the calibration run.

In a preferred embodiment, the updating the corresponding prestored DCIR value may further comprise updating DCIR values of the reference table in a predetermined vicinity of the updated DCIR value with an approximation based on the updated DCIR value.

The method may use an approximation based on the updated DCIR value to update values of the reference table that are in the vicinity of the updated corresponding DCIR value. In a vicinity refers to DCIR values that have temperature range or SOC value range that is close to the temperature range and SOC value range of the updated corresponding DCIR value. This feature may enhance the accuracy and reliability of the reference table by ensuring that the DCIR values in the vicinity of the updated value are also adjusted to reflect the most current data. This may enable a quicker and more precise identification of thermal runaway events by accounting for variations in the DCIR values that may occur due to changes in temperature and state of charge levels of the battery pack. The communication between components may involve the transmission of updated DCIR values to the reference table and the subsequent approximation of neighbouring values based on the updated DCIR value. This process may ensure that the reference table remains up-to-date and reflective of the current operating conditions of the battery cells, thereby improving the method's ability to detect early thermal runaway events.

In a preferred embodiment, the DCIR value may be obtained based on the battery cell current and the battery cell voltage. The battery cell current and battery cell voltage may be received right before a current pulse occurs and again after a delta time $\Delta t$ has elapsed. The current pulse may occur before the delta time $\Delta t$ ends and may last at least until the delta time $\Delta t$ ends. The delta time may e.g. last for 50 to 1000ms. The delta time may be determined in experiments. The delta time may vary depending on the battery cell dimensions, the battery cell type and battery cell technology.

According to the present disclosure, receiving the battery cell current and voltage right before a current pulse occurs, may refer to using the last battery cell current value and the last battery cell voltage value that was received before the current pulse occurred.

According to the present disclosure, receiving the battery cell current and voltage again after a delta time $\Delta t$ has elapsed, may refer to using the last battery cell current value and the last battery cell voltage value that was received before the delta time $\Delta t$ elapsed.

This timing mechanism may ensure that the measurements capture the immediate effects of the current pulse on the battery cell's internal resistance, thereby providing a more accurate and timely assessment of the DCIR value. This feature may enhance the method's ability to identify early thermal runaway events by ensuring that the DCIR value is obtained under consistent and controlled conditions, which may improve the reliability of the comparison with the prestored DCIR values in the reference table. The introduction of the current pulse and the specific timing for the measurements may also help in isolating the effects of transient conditions on the DCIR value, thereby reducing the likelihood of false positives or negatives in the identification of thermal runaway events. This may be particularly important in battery packs where the operating conditions can vary significantly, and transient events may otherwise obscure the true state of the battery cell's internal resistance. By ensuring that the current pulse lasts at least until the delta time ends, the method may provide a stable and consistent basis for the DCIR value obtaining, which may be critical for the accurate identification of thermal runaway events. Overall, the new feature introduced in the implementation may enhance the robustness, accuracy, and reliability of the early thermal runaway event identification method, thereby improving the safety and performance of battery packs.

According to an aspect of the invention, a processing unit is configured to carry out the method of the aforementioned aspect and/or any of its embodiment.

According to an aspect of the invention, a system comprises a processing unit and battery cells within at least one battery pack. The battery pack is composed of multiple battery cells. The processing unit is designed to execute a method for early detection of thermal runaway in battery cells, as detailed in any one of the preceding aspects.

According to the present disclosure, the term system may refer to a set of components that work together to perform specific functions.

According to the present disclosure, the processing unit may refer to a component that performs data processing tasks such as a computational unit or set of units capable of executing programmed instructions to carry out tasks, e.g. a microcontroller or microprocessor.

The advantage of this system is that it integrates a method for detecting thermal runaway, which is a critical safety concern in lithium-ion batteries. By using voltage and current measurements already available from the Battery Management System (BMS), the system can detect potential thermal runaway events without the need for additional sensors. This early detection allows for preventive measures to be taken, thereby enhancing the safety and reliability of the battery system.

Optionally, the system may comprise a battery management system, BMS, and/or an energy management system, EMS, and the processing unit is especially included in the BMS and/or the EMS of the system.

The specific mechanisms of communication between components may involve the processing unit interfacing with the BMS and/or EMS to manage and monitor the battery cells of the battery pack. This inclusion may allow for enhanced control and regulation of the battery cells, ensuring optimal performance and longevity of the battery pack. The new feature of incorporating the processing unit within the BMS and/or EMS may provide a more integrated and efficient system for managing the energy storage and distribution within the battery pack. This integration may facilitate real-time monitoring and adjustments, potentially improving the overall efficiency and safety of the system. Additionally, the processing unit's placement within the BMS and/or EMS may streamline the communication pathways, reducing latency and improving the responsiveness of the system to changing conditions. This configuration may also enable more sophisticated algorithms and control strategies to be implemented, further enhancing the system's ability to manage the battery cells effectively. Overall, the inclusion of the processing unit in the BMS and/or EMS may bring about significant improvements in the management and performance of the battery pack, contributing to a more reliable and efficient energy storage solution.

According to an aspect of the invention a computer-readable medium includes instructions which, when executed by a computer, cause the computer to perform a method as outlined in any one of previous implementations.

According to the present disclosure, a computer-readable medium may refer to any physical device that can store data readable by a computer, such as a hard drive, SSD, CD-ROM, USB drive, or cloud storage. The instructions stored on this medium are essentially a set of coded commands that, when executed by the computer's processor, enable the computer to carry out specific tasks or operations.

The advantage of this aspect lies in its ability to provide early detection of potential thermal runaway events in lithium-ion batteries without the need for additional hardware. By relying solely on voltage and current measurements, which are already available in most BMS systems, this method offers a cost-effective and efficient solution for enhancing battery safety and reliability. The early detection allows for timely intervention, thereby mitigating the risks associated with thermal runaway and improving the overall safety of battery-operated devices and systems.

According to an aspect of the invention a computer program product includes instructions which, when executed by a computer, enable the computer to perform a method as outlined in any one of previous implementations.

According to the present disclosure, a computer program product may refer to a tangible medium, such as a CD-ROM, USB drive, or downloadable software package, that contains the software instructions. These instructions are designed to be executed by a computer to carry out specific tasks.

According to the present disclosure, the term instructions may refer to the coded commands that the computer follows to perform the method. When these instructions are executed, they cause the computer to perform a series of steps or operations.

The advantage of this computer program product is that it allows for the implementation of the described method without the need for additional hardware. It leverages existing battery management systems to monitor and analyse battery conditions, thereby providing a cost-effective and efficient solution for enhancing battery safety and reliability. The early detection of thermal runaway can help prevent catastrophic failures and improve the overall performance and lifespan of Lithium-ion batteries.

BRIEF DESCRIPTION OF THE DRAWINGS

In the accompanying drawings,

figure 1 illustrates a schematic representation of an exemplary system;

figure 2 illustrates a schematic representation of a Thevenin model (Equivalent Circuit Model);

figure 3 illustrates a methodology for early thermal runaway detection;

figure 4 illustrates an update region based on SOC and temperature according to an optional aspect of the present disclosure; and

figure 5 is a flowchart illustrating a method and optional aspects according to the present disclosure.

DETAILED DESCRIPTION

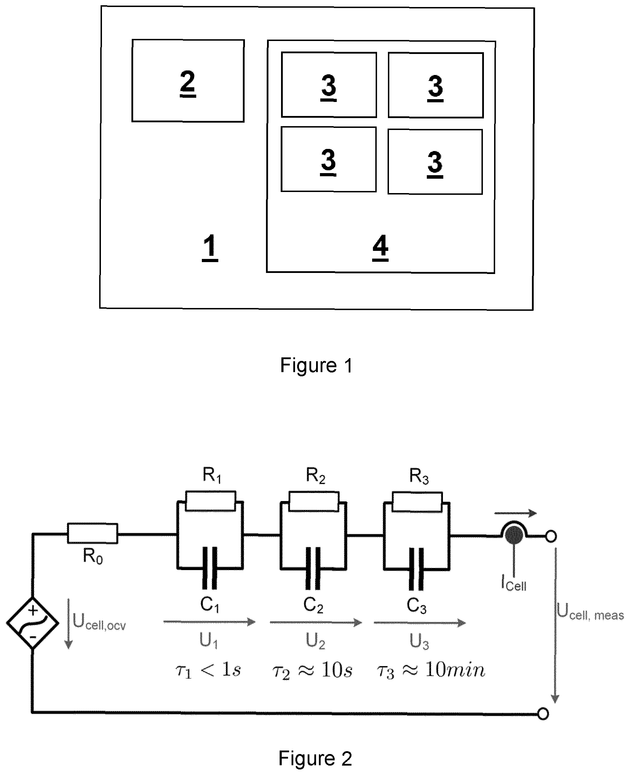

Figure 1 illustrates a system 1 according to the present disclosure. The system 1 comprises a processing unit 2, multiple battery cells 3, and at least one battery pack 4.

The processing unit 2 is configured for receiving a battery cell current of at least one of the multiple battery cells and a battery cell voltage of at least one of the multiple the battery cells. The processing unit 2 is further configured for receiving a temperature of the battery pack 4 and a state of charge, SOC, level of the battery pack 4. The processing unit 2 is further configured for obtaining a Direct Current Internal Resistance, DICR, value based on the battery cell current and the battery cell voltage and comparing the obtained DCIR value with a prestored DCIR value of a reference table at a same temperature range of the battery pack 4 and at a same SOC level range of the battery pack 4, wherein the reference table comprises a plurality of prestored DCIR values for a combination of different temperatures of the battery pack 4 and different SOC levels of the battery pack 4, wherein if a first condition is met, identifying a thermal runaway event, wherein the first condition comprises that the obtained DCIR value exceeds the prestored DCIR value by a first threshold.

Figure 2 illustrates the schematics of a Thevenin model, also known as Equivalent Circuit Model, which is often used to simulate battery cell dynamics. In the present disclosure, the Thevenin model is used to simulate the voltage response of the system 1 to a given load current profile.

This Thevenin model consists of three RC elements ($R_1$, $C_1$, $R_2$, $C_2$, $R_3$, $C_3$) connected in series, a series resistance $R_0$, and voltage source $U_{cell,OCV}$ modelling the Open Circuit Voltage (OCV) of the battery. The $R_0$ element is used to simulate battery dynamics that are faster than 50ms. It represents the sum of all ohmic resistances of the current collectors, active material, electrolyte and separator. Inductive impedance which starts to play a role at frequencies ≳500Hz are neglected as the current profiles studied typically do not contain relevant content at such high frequencies. Other frequency dependent impedance contributions from solid electrolyte interfaces, charge-transfer dynamics and diffusion processes on cathode and anode are most accurately modelled in electrochemical impedance spectroscopy experiments with constant phase elements and Warburg impedances. While these components are easily simulated in frequency space, they are difficult to work with in time domain. Instead, the frequency dependence of these components can be approximated with sufficient accuracy by using the three RC elements ($R_1$, $C_1$, $R_2$, $C_2$, $R_3$, $C_3$) with different time constants $\tau_i$ = Ri*Ci on the order of i={1s, 10s, 10min}.

The modelled voltage response $u_{cell}$ (t) of the battery cell 3 to a current input $i_{cell}$ (t) can be written as

$$u_{cell}(t) = u_{OCV}\big(soc(t)\big) + R_0\big(soc(t), T_{cell}(t)\big) * i(t) + u_1(t) + u_2(t) + u_3(t) \tag{1}$$

where $u_{OCV}(soc(t))$ is the OCV voltage as function of the State of Charge (SOC), *soc(t)*. The voltages $u_i(t)$ with $1 \le i \le 3$ represent the above-mentioned dynamics that are not included in $R_0$.

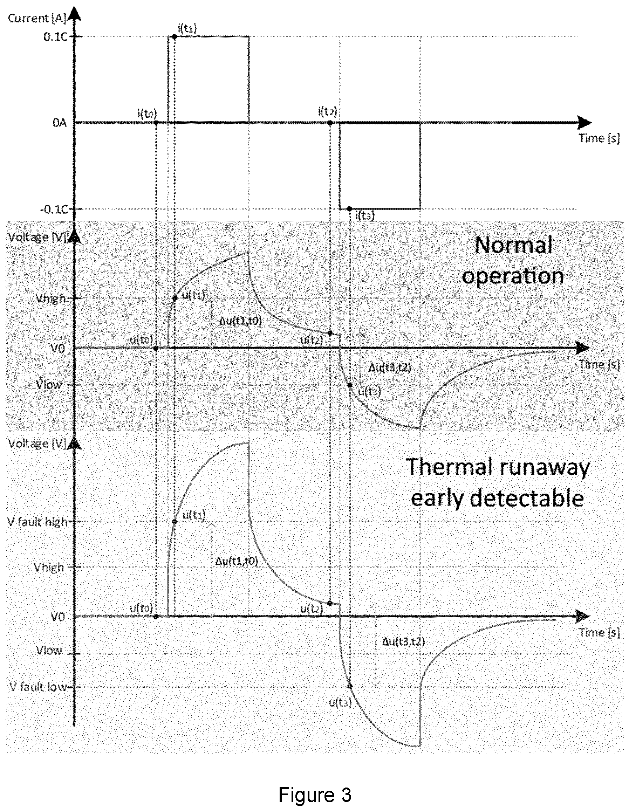

Figure 3 illustrates the methodology for early thermal runaway detection. For the ease of understanding, figure 3 illustrates the behaviour of an ideal system.

The first curve of figure 3 (upper illustration) illustrates that a current pulse of a reduced magnitude (e.g., 0.1C) is applied to the battery cell 3 in both charging and discharging direction, sequentially. The current of the charging pulse (in this ideal illustration shown as a generalised Dirac delta function) is shown on the y-axis and the x-axis plots the time. The second curve of figure 3 (middle illustration) illustrates the voltage curve (vertical axis) over time (horizontal axis) for a battery cell 3 under normal operation. Normal operation refers to the fact that the resulting DCIR value would not be identified as thermal runaway pending. The third curve of figure 3 (lower illustration) illustrates the voltage curve (vertical axis) over time (horizontal axis) for a battery cell 3 when the thermal runaway would be detectable via the resulting DCIR value (and an accordingly set first threshold).

The current pulse may be superimposed to the load cycle that is currently used in battery operation. Or, if the used load cycle shows enough dynamic variation, there is no need to inject a current pulse, as the dynamic load cycle could be used as source for estimation of the battery cell DC resistance. A sufficient dynamic may be given when at least a sufficient change in current of a at least a selected value (e.g., more than 0.1C) within a selected time period (e.g., 30 seconds) happens. The values for the minimum current (naturally regarded as an absolute value) and the time period can vary on the system 1 and its power state. In low noise systems, a lower minimum current is sufficient to receive clear readings. For times where the system 1 underlies low charging dynamics over time (e.g. no charge or discharge) and/or the battery pack's 4 temperature are low (e.g. lower than 40°C), the time period could be increased.

The Direct Current (DC) resistance can be calculated using the following equation:)

$$\Delta u_{cell}(t_1, t_0) = u_{cell}(t_1) - u_{cell}(t_0)$$
$$\approx R_0\big(soc(t_0), T_{cell}(t_0)\big) * [i(t_1) - i(t_0)] + \Delta u_1(t_1, t_0) + \Delta u_2(t_1, t_0) \tag{2}$$

where $\Delta u_i(t_1, t_0) = u_i(t_1) - u_i(t_0)$ for i=1, 2.

We take the $\Delta t = t_1 - t_0 = t_3 - t_2$ such that:

- The change in SOC is negligible, i.e. $soc(t_0) = soc(t_1)$. Therefore, the contribution due to the change in OCV is removed from the equation.

- The change in battery cell temperature is negligible.

- The contribution due to slow diffusion dynamics is negligible, i.e. $\Delta u_3(t_1, t_0) = \Delta u_3(t_3, t_2) = 0$.

The DC resistance is indicated as DCIR($\Delta$t) (Direct Current Internal Resistance) since its numerical value depends on the delta time between the measurement of the battery cell voltage after applying the current pulse and its measurement before application of such current pulse. The DCIR($\Delta$t) is obtained as follows by, taking reference to the charging pulse (positive current change, see Fig. 3: $i(t_0) \to i(t_1)$):

$$DCIR_{ch}(\Delta t) = \frac{\Delta u_{cell}(t_1, t_0)}{i(t_1) - i(t_0)}$$
$$= R_0\big(soc(t_0), T_{cell}(t_0)\big) + \frac{\Delta u_1(t_1, t_0) + \Delta u_2(t_1, t_0)}{i(t_1) - i(t_0)} \tag{3}$$

The same concept applies to the discharging pulse (negative current change, see Fig. 3: $i(t_2) \to i(t_3)$), such that $DCIR_{disch}(\Delta t)$ is also identifiable.

The algorithm is initialized by defining a $\Delta t$ and defining a nominal value of DCIR($\Delta t$,soc,T) that can be obtained by laboratory measurements. Once the $\Delta t$ is fixed, DCIR(soc,T) becomes a reference table, (e.g., Look Up Table (LUT)) that has two dimensions: SOC and battery cell temperature. To account for aging effects and/or the normal increase of the battery cell DCIR, the DCIR can be continuously obtained during lifetime using the methodology proposed by Equation 3. If newly obtained DCIR value are below any of the two first threshold and second threshold, the value could be used as an updated value and get stored in the reference table.

In the obtaining a DCIR value task, an updated value of resistance DCIR(soc,T) will be obtained upon occurrence of a current pulse. At this instance, the corresponding values of SOC and temperature from measurement devices can be received (and may be assigned to the dedicated temperature range and SOC level range of the reference table). The nearest point available in the LUT to the operating condition (SOC, T) may be defined as the 'Update Point'.

Ideally, only the 'Update Point' shall be updated with the accordingly obtained DCIR value. But in this case, a complete SOC and temperature range operation must be undergone before all the points in LUT are updated. This might not be possible in the application and would lead to the problem that some points in the reference table are not updated. Additionally, it can require a great amount of time to fetch points for all the allowed temperatures and SOC. Considering these factors, an Update Region is determined around the Update Point.

*UpdatePoint:* (*SOC, T*)
*UpdateRegion:* (*SOC* + SOCRange, T $\pm$ TRange)

The SOC and temperature ranges would determine the distance up to which the influence of newly found *DCIR* (*soc, T*) value will be propagated in the LUT.

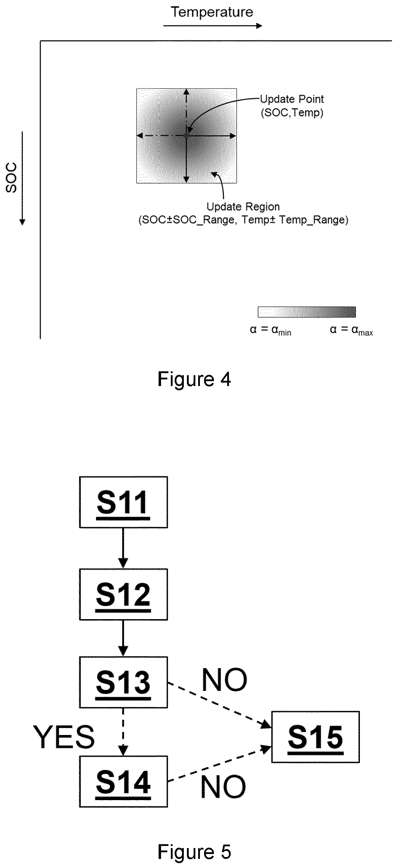

Figure 4 illustrates the interpretation of such an Update Region graphically. The temperature is illustrated horizontally and the SOC level vertically (interchangeable).

Thus, the Update Region will be modified with newly found *DCIR(soc,T)* value instead of only updating the Update Point. If a part of Update Region lies outside the LUT operational limits of SOC and Temperature, the Update Region will be modified only up to the LUT limits.

An update coefficient $\alpha$ will be considered which will determine the weight for the newly found parameter value (*DCIR*) during update task. The updated parameter value can be given as,

$$DCIR_{updated}(soc, T) = \alpha DCIR_{new}(soc, T) + (1 - \alpha)DCIR_{table}(soc, T) \tag{4}$$

The value of the update coefficient $\alpha$ for a particular point in the update region would depend on the distance between that point and the Update Point. It is given as

$$\alpha \sim \frac{1}{\sqrt{\Delta SOC^2 + \Delta T^2}} \tag{5}$$

$$0 \leq \alpha \leq 1$$

where $\Delta$SOC = "SOC at the point under consideration in Update Region" - "SOC at Update point ", and

$\Delta$T = "Temperature at the point under consideration in Update Region" - "Temperature at Update point".

Figure 5 is a flowchart illustrating a method according to the present disclosure and optional aspects.

The method comprises:

A step S11 of receiving a battery cell current and a (single) battery cell voltage of the battery cell 3. Further, also receiving a current temperature and current SOC level of the battery pack 4.

A step S12 of determining a DICR value using the battery cell current and the battery cell voltage.

A step S13 of comparing the determining DICR value with a prestored DCIR value that has a same temperature and SOC value level (same temperature and SOC value level refers to a similar temperature and a similar SOC level that are in the same temperature range and SOC level range). And when the DICR value (determined in step S12) exceeds the value of the prestored DCIR value by a first threshold, a first condition is met. Meeting the first condition identifies a pending thermal runaway event.

Optionally, a step S14 of determining an average DCIR value of a plurality of the battery cells 3 of the battery pack 4, at a same temperature and SOC level of the batter pack 4. And if the first condition of step S13 is met, determining if the DICR value (determined in step S12) exceeds an average DCIR value threshold. And when the second threshold is met, the pending thermal runaway event is confirmed.

Optionally, a step S15 of updating the DCIR value in the reference table that is assigned to a same temperature range and SOC level range like the temperature and SOC level of the DCIR value determined in step S12, if none of a first and/or second condition is met, with the DICR value determined in step S12.

While the invention has been illustrated and described in detail in the drawings and foregoing description, such illustration and description are to be considered exemplary and not restrictive. The invention is not limited to the disclosed embodiments. In view of the foregoing description and drawings it will be evident to a person skilled in the art that various modifications may be made within the scope of the invention, as defined by the claims.

**Claims**

1. An early thermal runaway event identification method of a battery cell (3), wherein a plurality of battery cells (3) are comprised in a battery pack (4) and the method comprises:

   receiving (S11) a battery cell current of the battery cell (3) and a battery cell voltage of the battery cell (3);
   receiving (S11) a temperature of the battery pack (4) and a state of charge, SOC, level of the battery pack (4);
   obtaining (S12) a Direct Current Internal Resistance, DICR, value based on the battery cell current and the battery cell voltage;
   comparing (S13) the obtained DCIR value with a prestored DCIR value of a reference table at a same temperature range of the battery pack (4) and at a same SOC level range of the battery pack (4), wherein the reference table comprises a plurality of prestored DCIR values for a combination of different temperatures of the battery pack (4) and different SOC levels of the battery pack (4), wherein
   if a first condition is met, identifying a thermal runaway event, wherein the first condition comprises that the obtained DCIR value exceeds the prestored DCIR value by a first threshold.

2. The method according to claim 1, wherein the comparing the obtained DCIR value with a prestored DCIR value further comprises:

obtaining (S14) an average DCIR value at the same temperature range of the battery pack (4) and at the same SOC level range of the battery pack (4) of a plurality of the battery cells (3) of the battery pack (4), and when the first condition is met, validating the thermal runaway event, when a second condition is met, wherein the second condition comprises that the obtained DCIR value exceeds the average DCIR value by a second threshold.

3. The method according to any of the preceding claims, wherein the receiving a battery cell current of the battery cell (3) and a battery cell voltage of the battery cell (3), further comprises that the battery cell current and the battery cell voltage are received before and after a current change of the battery cell (3).

4. The method according to any of the preceding claims, wherein, if the thermal runaway event is detected, reducing a load of the battery cells (3), and/or decreasing the temperature of the battery cells (3).

5. The method according to any of the preceding claims, wherein the current change is externally induced.

6. The method according to any of the preceding claims, wherein the receiving the battery cell current and the battery cell voltage is performed regularly, in particular at least every 30 seconds, the current pulse is at least 0,1 C, and the current pulse lasts at least 1 second.

7. The method according to any of the preceding claims, wherein the battery cell current and the battery cell voltage are provided by a battery management system, BMS, of the battery pack (4).

8. The method according to any of the preceding claims, wherein the reference table comprises a charge table and/or a discharge table,

    wherein the charge table comprises a plurality of prestored DCIR values for a combination of different temperatures of the battery pack (4) and different SOC levels of the battery pack (4) during a charge event of the battery cell (3),
    wherein the discharge table comprises a plurality of prestored DCIR values for a combination of different temperatures of the battery pack (4) and different SOC levels of the battery pack (4) during a discharge event of the battery cell (3).

9. The method according to any of the preceding claims, wherein the comparing the obtained DCIR value with a prestored DCIR value further comprises:
    if neither the first condition nor the second condition are met, updating (S15) the corresponding prestored DCIR value of the reference table with the obtained DCIR value.

10. The method according to claim 9, wherein the updating the corresponding prestored DCIR value further comprises: updating DCIR values of the reference table in a predetermined vicinity of the updated DCIR value with an approximation based on the updated DCIR value.

11. The method according to any of the preceding claims,
    wherein the DCIR value is obtained based on the battery cell current and the battery cell voltage, and the battery cell current and the battery cell voltage are receiving right before the current pulse occurs and a delta time $\Delta t$ later, wherein the current pulse occurs before the delta time $\Delta t$ ends, and the current pulse lasts at least until the delta time $\Delta t$ ends.

12. A processing unit (2) being configured to carry out the method of any one of claims 1 to 11.

13. A system (1) comprising a processing unit (2), battery cells (3) of at least one battery pack (4), wherein the battery pack (4) comprises multiple battery cells (3), and the processing unit (2) is configured to carry out the method of any one of claims 1 to 11.

14. A computer-readable medium comprising instructions which, when executed by a computer, cause the computer to carry out the method of any one of claims 1 to 11.

15. A computer program product comprising instructions which, when the program is executed by a computer, cause the computer to carry out the method of any one of claims 1 to 11.

Figure 1

Figure 2

Figure 3

Temperature →

SOC ↓

Update Point
(SOC,Temp)

Update Region
(SOC±SOC_Range, Temp± Temp_Range)

$\alpha = \alpha_{min}$    $\alpha = \alpha_{max}$

Figure 4

**S11**

**S12**

**S13** --- NO

YES

**S14** --- NO

**S15**

Figure 5

Europäisches
Patentamt

European
Patent Office

Office européen
des brevets

# EUROPEAN SEARCH REPORT

**Application Number**

EP 24 21 9136

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 102 072 247 B1 (HYUNDAI MOBIS CO LTD [KR]) 31 January 2020 (2020-01-31) | 1-8, 11-15 | INV. B60L3/00 |
| A | * paragraphs [0008] - [0035] * | 9,10 | B60L58/12 B60L58/25 |
| A | US 2021/408615 A1 (MYERS ROBERT L [US] ET AL) 30 December 2021 (2021-12-30) * paragraph [0076] * | 1-15 | B60L58/26 G01R31/3842 G01R31/389 H01M10/48 |
| A | US 2022/357405 A1 (RISE GREGORY [US] ET AL) 10 November 2022 (2022-11-10) * figure 4 * | 1-15 | H01M10/42 H01M10/44 H01M10/613 |
| A | CN 110 568 375 A (KUNSHAN BAOCHUANG NEW ENERGY TECH CO LTD) 13 December 2019 (2019-12-13) * figure 2 * | 1-15 | |
| A | CN 118 294 833 A (SUNWODA POWER TECHNOLOGY CO LTD) 5 July 2024 (2024-07-05) * figure 1 * | 1-15 | |
| A | US 11 693 060 B2 (TOSHIBA KK [JP]; TOSHIBA ENERGY SYSTEMS & SOLUTIONS CORP [JP]) 4 July 2023 (2023-07-04) * figure 10 * | 1-15 | **TECHNICAL FIELDS SEARCHED (IPC)** B60L G01R H01M |

The present search report has been drawn up for all claims

| Place of search | Date of completion of the search | Examiner |
|---|---|---|
| The Hague | 13 May 2025 | Chevret, Anthony |

EPO FORM 1503 03.82 (P04C01)

# EP 4 759 606 A1

## ANNEX TO THE EUROPEAN SEARCH REPORT
## ON EUROPEAN PATENT APPLICATION NO.

EP 24 21 9136

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2025

| Patent document cited in search report | | | Publication date | Patent family member(s) | | Publication date |
|---|---|---|---|---|---|---|
| KR 102072247 | B1 | | 31-01-2020 | CN | 104300186 A | 21-01-2015 |
| | | | | KR | 20150009312 A | 26-01-2015 |
| US 2021408615 | A1 | | 30-12-2021 | US | 2021408615 A1 | 30-12-2021 |
| | | | | US | 2024266624 A1 | 08-08-2024 |
| US 2022357405 | A1 | | 10-11-2022 | NONE | | |
| CN 110568375 | A | | 13-12-2019 | NONE | | |
| CN 118294833 | A | | 05-07-2024 | NONE | | |
| US 11693060 | B2 | | 04-07-2023 | EP | 3429053 A1 | 16-01-2019 |
| | | | | JP | 6571268 B2 | 04-09-2019 |
| | | | | JP | WO2017154112 A1 | 13-12-2018 |
| | | | | KR | 20180122378 A | 12-11-2018 |
| | | | | US | 2019081369 A1 | 14-03-2019 |
| | | | | WO | 2017154112 A1 | 14-09-2017 |

EPO FORM P0459

For more details about this annex : see Official Journal of the European Patent Office, No. 12/82